# EUROPEAN PATENT APPLICATION

(11) **EP 2 339 612 A1**
(43) Date of publication of application: **29.06.2011**
(21) Application number: 11156863.0
(22) Date of filing: 14.04.2004
(51) Int. Cl.: H01L 21/311, C04B 41/80

(54) **Semiconductor processing component**

(30) Priority: 15.04.2003 US 414563
(62) Divisional of application: 04759531.9
(71) Applicant: Saint-Gobain Ceramics and Plastics, Inc., Worcester, MA 01615-0138 (US)
(72) Inventor: Narendar, Yeshwanth, Westford, MA 01886 (US); Buckley, Richard, F., Shrewsbury, MA 01545 (US); Haerle, Andrew G., Sutton, MA 01590 (US); Hengst, Richard R., Oakham, MA 01068 (US)
(74) Representative: Zimmermann & Partner

(57) **Abstract**

Various semiconductor processing components and methods for forming same are disclosed. In one embodiment a semiconductor processing component is formed of SiC, and an outer surface portion of the component has a surface impurity level that is not greater than 10 times a bulk impurity level. In another embodiment a method for treating a semiconductor processing component includes exposing the component to a halogen gas at an elevated temperature, oxidizing the component to form an oxide layer; and removing the oxide layer.

## Description

### TECHNICAL FIELD

The present invention is generally related to methods for treating semiconductor processing components for use in a semiconductor fabrication environment, as well as semiconductor processing components formed thereby.

### BACKGROUND ART

In the art of semiconductor processing, typically integrated circuit devices are formed through various wafer processing techniques, in which semiconductor (principally silicon) wafers are processed through various station or tools. Processing operations include, for example, high temperature diffusion, thermal processing, ion implant, annealing, photolithography, polishing, deposition, etc. As new generation semiconductor devices are developed, there is an intense demand in the industry to achieve better and better purity levels during such processing operations. In addition, there continues to be an intense driving force in transitioning to larger and larger semiconductor wafers. Currently, the semiconductor industry is undergoing a transition from 200mm to 300mm wafers. The desire for superior purity levels and larger wafers introduces further integration challenges for next generation processing.

In this context, it has been found that as wafer size increases, the gravitational stresses caused by the increased mass of the wafers and increased surface area, cause what is understood as crystallographic slip in the semiconductor wafer. Crystallographic slip manifest itself as slip lines in the wafer which cause a decrease in device yield proportional with an increase in wafer size, and undermine some of the cost advantages associated with larger surface area wafers.

In an attempt to minimize crystallographic slip, wafers need to be more fully supported during processing operations. One technique is to machine the semiconductor processing components to provide a smooth finish particularly along those portions of the processing component that contact the wafer. Such processing components include semiconductor wafer jigs, horizontal and vertical wafer boats, and wafer carriers, for example. Typically, the improved surface finish can be accomplished by machining slots into a wafer carrier or jig. While appropriate surface finishes may be engineered into the semiconductor processing component utilizing existing technology, additional issues have arisen, and in particular, a decrease in purity and attendant increase in contamination of the processing component.

US Patent 6,093,644 discloses a process in which an oxidation step is carried out, followed by oxide layer removal. However, the techniques disclosed therein do not adequately address certain contamination issues, and appear to focus on global impurity levels of the component, and not impurity levels along critical portions of the component,

Despite improvements in the industry to address next generation purity concerns as well as handling issues associated with larger-sized semiconductor wafers, a need continues to exist in the art for further improved semiconductor processing components, methods for forming such components, and methods for processing semiconductor wafers.

Still further, in other applications, machining is not required or may be optional, as in the case of free-standing semiconductor processing components such as SiC components formed by CVD (chemical vapor deposition). While it has generally been commonly believed that as-formed CVD SiC components have exceptional characteristics for semiconductor processing operations, a need continues to exists in the art for further improved components and methods for forming and using same.

### DISCLOSURE OF INVENTION

According to one aspect of the invention, an embodiment calls for a method for treating a semiconductor processing component is provided. According to the method, the semiconductor processing component is exposed to a halogen gas at an elevated temperature, and oxidized to form an oxide layer. After formation of the oxide layer, the oxide layer is removed.

According to another embodiment, a method for removing a contaminant from a semiconductor processing component is provided, in which the contaminant is reacted at an elevated temperature to form a reaction product, the component is oxidized to form an oxide layer, and the oxide layer is then removed.

According to another embodiment, a semiconductor processing component is provided. The , semiconductor processing component contains silicon carbide, and has a surface roughness having an Rₐ less than about 2 microns and an impurity content of less than about 1000 ppm along an outer portion of the component, as measured by SIMS depth profiling at a depth of 10 nm below the outer surface. This outer portion extends from an exposed outer surface of the component to a depth of about 0.5 microns below the exposed outer surface of the component. The outer portion may extend along a portion of the outer surface of the component, or extend over essentially the entirety of the outer surface of the component.

According to yet another embodiment, a semiconductor processing component is provided, the component having a machined surface, and an impurity content less than about 1000 ppm along an outer portion of the component, the outer portion being described above.

According to yet another embodiment, a semiconductor processing component is provided for receiving a semiconductor wafer. In this embodiment, the processing component is configured to contact and receive a semiconductor wafer. The component has surface roughness Rₐ less than about 2 microns, and an impurity content less than about 1000 ppm along an outer portion of the component.

According to a second aspect of the invention, a further embodiment calls for a semiconductor processing component, the component comprising silicon carbide, wherein an outer surface portion of the component has a surface impurity level and a bulk impurity level. Preferably, the surface impurity level is not greater than ten times the bulk impurity level.

According to another embodiment, a method for treating a semiconductor processing component is provided. The method begins with provision of a semiconductor processing component having an outer surface portion formed by chemical vapor deposition of silicon carbide, the outer surface portion having a bulk impurity level and a surface impurity level. Further, a target portion of the outer surface portion is removed, such that the surface impurity level is not greater than about ten times the bulk impurity level.

Still further, according to another embodiment, a method for treating a semiconductor processing component is provided. The method begins with provision of a semiconductor processing component having an outer surface portion formed by chemical vapor deposition of silicon carbide. The outer surface portion has a bulk impurity level and a surface impurity level. Further, the method continues with removal of a target portion of the outer surface portion, such that the surface impurity level is reduced by a factor of at least ten.

### BRIEF DESCRIPTION OF THE DRAWINGS

The present invention may be better understood, and its numerous features and advantages made apparent to those skilled in the art by referencing the accompanying drawings.
FIG. 1 illustrates an embodiment of the present invention, namely a wafer boat or carrier.
FIGS. 2 and 3 illustrate the impurity depth profile of CVD-SIC films formed in two different commercially available deposition apparatuses.
FIG. 4 illustrates the impurity depth profile of CVD-SiC, formed utilizing reactant gases at higher contaminant levels.
FIG. 5 illustrates the impurity depth profile of a CVD-SiC layer before and after an initial cleaning step.
FIG. 6 illustrates a depth profile resulting from two cleaning cycles of another sample, having a relatively low-purity CVD-SiC layer.

The use of the same reference symbols in different drawings indicates similar or identical items.

### MODES FOR CARRYING OUT THE INVENTION

According to a first aspect of the invention, an embodiment calls for a method for treating a semiconductor processing component. The semiconductor processing component subject to treatment may be chosen from one of various geometric configurations for different processing operations, and may be configured for receiving various sized wafers, whether 150mm, 200mm, or newer generation 300mm wafers, for example. Particular processing components include semiconductor wafer paddles, process tubes, wafer boats, liners, pedestals, long boats, cantilever rods, wafer carriers, vertical process chambers, and even dummy wafers. Of the foregoing, several of the semiconductor processing components may be those that are configured for direct contact with and for receiving semiconductor wafers such as horizontal or vertical wafer boats, long boats, and free-standing CVD SiC wafer susceptors. In addition, the processing component may be configured for single wafer processing and may be used for chambers, focus rings, suspension rings, susceptors, pedestals, etc.

The semiconductor processing component may be fabricated by various techniques. For example, according to one embodiment, the processing component is formed by provision of a silicon carbide substrate, which is then impregnated with molten elemental silicon. Optionally, the impregnated silicon carbide component may be coated with a high purity layer, such as silicon carbide by chemical vapor deposition (CVD). This deposited layer may advantageously prevent auto-doping of the underlying silicon, as well as prevent migration of impurities from the bulk of the substrate to an outer surface of the component, which may lead to contamination during semiconductor wafer processing. In this case, a silicon carbide member functioning as a core, for impregnation with molten silicon, provides the mechanical support of the component. This core may be manufactured by various techniques, most commonly slip casting silicon carbide, or by a pressing technique. Other specialized techniques may also be used, such as by utilizing a conversion process in which a carbon preform is converted into a silicon carbide core, or by subtractive process in which the core is removed following infiltration, such as by chemical vapor infiltration.

Alternatively, the semiconductor processing component may be formed of stand-alone silicon carbide, formed of one of various processes such as by CVD of silicon carbide. This particular process technique enables formation of a processing component that is of relatively high purity. Further, the processing component may be formed of a conventional material such as quartz. In this regard, quartz diffusion components have been utilized in the semiconductor industry for high temperature diffusion operations, and are a cost effective alternative to the more expensive but better performing silicon carbide-based diffusion components. However, features of the present invention may be particularly applicable to silicon carbide-based semiconductor processing components, such as those that are machined during the fabrication process, discussed in more detail below.

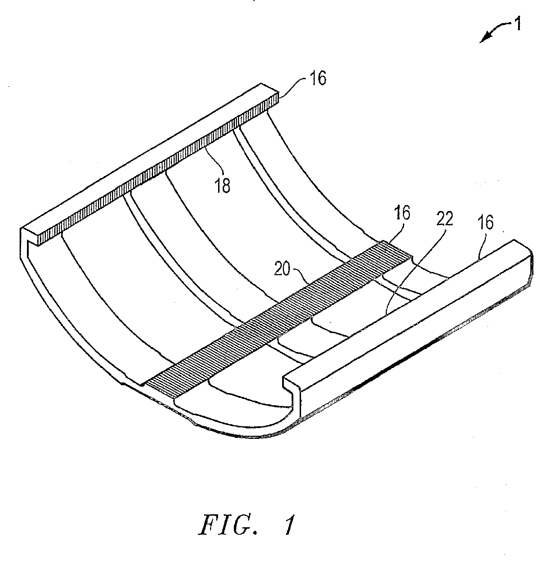

At the back-end of the fabrication process for forming a semiconductor processing component according to embodiments of the present invention, the component may be machined. In particular, as in the case of wafer boat 1 illustrated in FIG. 1, a wafer boat is provided having a plurality of grooves 16, each of which extends along the same radius of curvature. Each groove has an individual groove segment 18, 20 and 22, which are desirably machined following fabrication of the wafer boat proper. For example, the wafer boat may be fabricated according to one of the techniques described above, such as by impregnating a silicon carbide core with molten elemental silicon, then executing CVD to form a deposited silicon carbide layer. Following formation of the silicon carbide layer, the grooves may be formed and fine dimensional control may be executed by a machining operation, such as by utilizing a diamond-based machining tool. In this regard, while prior fabrication techniques have attempted to deal with impurity introduction during the machining stage by utilizing very high purity machining tools, features of the present invention enable utilization of a fairly wide range of machining tools and operations, as will be discussed below. Noteworthy, while FIG. 1 illustrates a horizontal wafer boat, it is to be understood that vertical wafer boats or wafer carriers may be utilized as well, as well as other semiconductor processing components as already mentioned.

Following formation of the processing component, and optionally machining operations, the processing component is exposed to a halogen gas at an elevated temperature. Use of the term "halogen gas" denotes use of any halogen group elements provided in gaseous form, typically combined with a cation. An example of a common halogen gas which may be employed according to embodiments of the present invention includes HCL Other gasses include those that contain fluorine, for example. Typically, the elevated temperature at which the semiconductor processing component is exposed to the halogen gas is sufficient to enable a reaction between the halogen gas and impurities contained along an outer surface portion of the semiconductor processing component, including along the exposed outer surface of the semiconductor processing component. For example, the elevated temperature may be within a range of about 950° C to about 1300° C. Further, the concentration of the halogen gas may vary, and may be present in the heated environment (e.g., a furnace processing chamber) within a range of about 0.01 to about 10% of the total pressure. Typically, the lower limit of the partial pressure is somewhat higher, such as about 0.05, or about 0.10%.

Typically, the impurity with which the halogen gas reacts along an outer surface portion of the semiconductor processing component is a metal impurity. Metal impurities may take on the form of elemental metal, or metal alloys, and may be aluminum-based or iron-based, for example. The source of the metal impurity is oftentimes due to back-end machining, as discussed above. The actual composition of the machine tool may include a certain level of contaminants. Even more likely, the machining operation is carried out by use of an apparatus having structural metallic components which generate particulates, which eventually end up being deposited on or otherwise transferred to the processing component. As such, common impurities include those metals that are commonly used for formation of industrial machining tools, including tool steels. The use of a halogen gas such as HCl causes the formation of a reaction product with such metal impurities. The reaction product typically has a higher volatilization than the impurities, such that during the exposure of the processing component to the elevated temperature, the reaction product volatilizes and is thus removed from the processing component.

In connection with the foregoing impurity reduction of the components, it is noted that while the foregoing has primarily focused on silicon carbide components (including free standing CVD SiC, recrystallized CVD, Si-impregnated SiC), the impurity reduction techniques maybe equally applicable to components formed of other materials, such as quartz. Whatever the base material of component, machined components such as those having a fine surface finish (as discussed in more detail hereinbelow), are particularly good candidates for impurity reduction.

The semiconductor processing component may also be subjected to an oxidizing treatment, which may aid in further impurity reduction and/or particle count reduction, particularly in the case of silicon carbide components. The oxidation of the semiconductor processing component is carried out to form an oxide layer by chemical reaction to form a conversion layer, as opposed to a deposited oxide layer. The exposure of the processing component to halogen gas and the oxidation of the component may be carried out separately. However, in one embodiment, both the exposing and oxidizing steps are carried out simultaneously. In this regard, use of the term simultaneously does not require that the exposure and oxidation steps are carried out so as to be completely coextensive, but rather, the steps may overlap each other partially.

According to the oxidation treatment, an oxide layer is provided so as to overlie the semiconductor processing component. In this regard, the oxide layer may directly overlie and contact an underlying silicon carbide layer, such as in the case of chemical vapor deposited silicon carbide, or may directly overlie and contact elemental silicon, as in the case of siliconized silicon carbide processing components which do not have an overlying CVD SiC layer.

The oxide layer may be formed by oxidation of the component in an oxidizing environment, such as by oxidizing the component in an oxygen containing environment at an elevated temperature, such as within a range of 950 to about 1300 degrees C, and more generally in a range of about 1000 to about 1250 degrees C. Oxidation may be carried out in a dry or wet ambient, and is typically carried out at atmospheric pressure. A wet ambient can be generated by introducing steam, and functions to increase the rate of oxidation. The oxide layer is generally silicon oxide, typically SiO₂. The silicon oxide layer may be in direct contact with the silicon carbide of the component, as in the case of free-standing SiC or substrates coated with silicon carbide, such as by CVD. Alternatively, an intermediate layer, such as silicon may be present between the silicon carbide of the substrate and the overlying oxide layer, as in the case of silicon-impregnated silicon carbide, which has no SiC CVD layer.

According to embodiments of the present invention, formation of the oxide layer may cause residual silicon carbide particulates to be converted to silicon oxide, in addition to formation of an oxide layer along the body proper. In the case of particulate conversion, oxidation may enable later stage particulate removal. In addition, formation of an oxide coating by a conversion process, rather then a deposition process, helps trap residual impurities, such as metallic impurities, within the oxide layer, for removal along with the oxide layer. The oxide layer may be removed by exposure of the processing component to a solution that is capable of solubilizing (dissolving) the oxide layer. In one embodiment, the solution is an acid which contains fluorine. Typically, the pH of the solution is less than about 3.5, most typically less than about 3.0, with some embodiments being even more acidic, having a pH less than about 2.5. Alternatively, the solution may be basic, and exposed to the layer in conjunction with elevated temperatures (greater than room temp, but below H2O boiling point). Alternatively, high temperature and H2 gas, such as above 1000°C, may also be used.

According to another feature, the execution of exposing the processing component to a halogen gas, oxidizing the component to form an oxide layer, and removing the oxide layer, are all carried out prior to use of the processing component in a semiconductor fabrication environment. As such, the foregoing steps may be carried out off site, separate from the semiconductor fabrication environment, such as by the manufacturer of the processing component. The processing component may be fully treated, then packaged in a hermetic shipping container for direct and immediate use in a fabrication environment. While the foregoing has focused on one cycle, the halogen gas treatment and/or oxidation and removal steps may be repeated several times to achieve the desired level of purity.

While the foregoing has mentioned use of a halogen gas, other reactive anion-containing reactants may be utilized, provided that the reactant is chosen so as to form a reaction product with expected metallic impurities, and that the reaction product has a higher volatility then that of the metallic impurity itself.

According to a variant, additional processing steps may be incorporated prior to exposure to the halogen Species, oxidation, and oxide removal, with an aim to further reduce impurity levels. For example, the component may be rinsed, such as with deionized (DI) water, prior to exposure to halogen gas and subsequent processing. Agitation may be carried out during rinsing, such as with an ultrasonic mixer/agitator, to further supplement contaminant removal. Further, the rinsing solution may be acidic solution to aid in stripping the contaminants.

Alternatively, or in addition to rinsing, the component may be immersed in an acidic stripping solution prior to halogen species exposure, such as an acidic solution, to further aid in impurity removal. The rinsing and/or immersion steps may be repeated any number of times prior to further processing.

Further, semiconductor processing components having various features are provided according to embodiments of the present invention. For example, a processing component comprising silicon carbide is provided having a surface roughness Rₐ less than about 2 microns, and an impurity content less than about 1000 ppm (as measured by SIMS depth profiling at depth of 10 nm below the outer surface) along an outer portion of the component In the case of components which directly contact wafers, such as a supporting jig or wafer boat, the surface portion having the above noted Rₐ typically includes at least that portion of the component configured for this contact, such as the slots in a wafer boat. The above noted outer portion having controlled purity is generally defined as a portion of the component extending from an exposed outer surface to a depth of about 0.5 microns as measured by SIMS depth profiling below the exposed outer surface. According to one embodiment, this outer portion extends along essentially the entire outer area of the component, and actual impurity level data taken from several locations which are taken as representative of the purity level of the outer portion. By execution of a machining step such as by utilizing a diamond grinding tool, the surface roughness may be reduced to an Rₐ less than about 2 microns. Alternatively, different fabrication techniques may be used to form an as-formed processing component having such a surface roughness. Certain embodiments may have a surface roughness less than about 1.5 microns, such as less than about 1.0 microns.

The impurity content may be reduced to within the above-noted level along the outer portion of the component by following the process techniques described herein, for example. Preferably, this impurity content is less than about 500 ppm, preferably less than about 200 ppm. Certain embodiments have even a further suppressed impurity content, such as less than 100 ppm, and less than 80 ppm total. The foregoing impurties levels are the total impurity contents from the total of B, Na, Al, Ca, Ti, V, Cr, Fe, Ni, Cu, and Zn. While prior processes have executed oxidation and oxidation layer removal steps as described above in the Background, the present inventors have recognized that such prior processes generally result in components having significant impurity levels, notably above the levels provided by present invention as described herein. Such prior techniques result in purity limits in excess of those desired for semiconductor industry applications. In addition, it has been found that processing component manufacturers have taken impurity contents across the entirety of the component (including through the bulk material), rather than along that portion which is particularly critical. This outer portion of the component is susceptible to undesirable diffusion into and contamination of the semiconductor fabrication environment. Accordingly, embodiments of the present invention do not only provide global impurity levels meeting or exceeding industry standards, but also suppress impurity levels along the critical outer surface portion of the component.

### Examples

Table 1 shows the roughness results of CVD SiC samples prepared under a variety of conditions. Ra is defined as the average surface roughness. More precisely, it is the arithmetic mean of the departures of the profile from the mean line. Ra = 1/L₀□^{L} |z (x) | dx. Rz is defined as the average height difference between the five (5) highest peaks and the five (5) lowest valleys within the sampling length or stroke length (Stroke L). Stroke length is the length over which the values of surface roughness parameters were assessed.

Samples 1, 2, and 3 show roughness of as-deposited CVD SiC coatings. These results are obtained using a profilometer and using a 10 *µ*m stylus and either a 3 to 6.4 mm stroke length. Samples 3, 4, 5, 6, and 7 are CVD SiC coatings that have undergone a surface treatment using diamond material, either by machining with a wheel or lapping and polishing with a diamond paste. As can be seen from the table, machining the CVD SiC acts to significantly reduce the surface roughness of the material. FS CVD denotes a free standing chemical vapor deposited component.

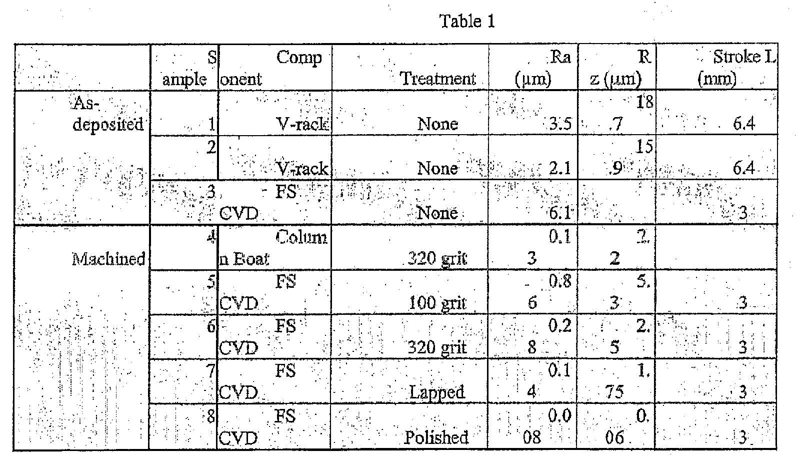

Table 2 shows surface purity results of an as-deposited CVD SiC film, and CVD SiC films that have undergone a post-machining step with a diamond tool. The surface purity is quantified using Secondary Ion Mass Spectroscopy (SIMS) at a nominal depth of 10 nm, and the following impurities made up the total: B, Na, Al, Ca, Ti, V, Cr, Fe, Ni, Cu. Sample 9 shows a fairly high-purity as-deposited coating. In contrast, after machining and rinsing with DI water, Sample 10 shows high contamination levels. In this regard, another sample subjected to machining and DI rinse showed even higher levels, on the order of 5000 ppm total. After being cleaned in an ultrasonic tank using DI water, Sample 11 was further processed using a chlorinated oxidation process. HC1 concentration ranged from 1 to 3% based on oxygen through the cycle, and the maximum temperature was 1300 °C. The oxide grown on Sample 11 was removed using a 4:1:1 DI Water:HF:HC1 recipe (acid strip). SIMS data was obtained on this machined, treated CVD SiC film. It can be seen that the impurities were greatly reduced, and the purity is very close to the as-deposited condition.

Sample 12 was processed similarly to described above, except that a 4:1:1 DI water:HF:HCl immersion step was added after the ultrasonic DI rinse and prior to the chlorinated oxidation. As can be seen from the results, this methodology was effective in reducing the surface impurities on the machined CVD SiC material back to the initial starting level (as deposited).

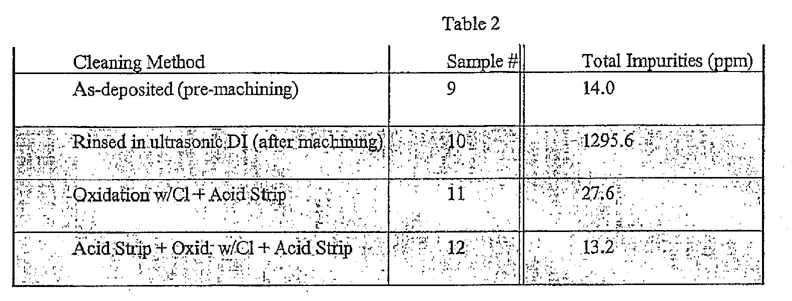

According to another aspect of the present invention, a semiconductor processing component, and a method for treating a semiconductor processing component are provided. The semiconductor processing component generally is formed at least partially of SiC, including an outer surface portion that has a controlled impurity content. The outer surface portion is typically formed by chemical vapor deposition (CVD), and has an outer purity that is not greater than ten times a bulk purity. The outer surface portion may be defined as an identifiable SiC layer formed by CVD, or an outer thickness of a SiC component formed principally by CVD, as in the case of free-standing CVD-SiC components, described in more detail below.

According to one aspect, the present inventors have recognized that as-deposited CVD-SiC (whether or not machined) has a spike in impurity levels at the outer surface thereof, typically within the first 0.5 µm, such as within the first 0.25 *µ*m or the first 0.10 *µ*m of the outer depth of the component. While, in contrast, the impurity level through the bulk of the outer surface portion stabilizes at a relatively low level, oftentimes one, two, or even three orders of magnitude lower than an impurity level at the very outer surface of the component. The bulk impurity level is generally that impurity level which represents the constant or nominal impurity level as a function of depth, and is further described hereinbelow. The foregoing a phenomenon is generally not recognized in the art, and rigorous analysis of as-deposited CVD-SiC layers has revealed a significant spread in impurity levels. Impurity levels are generally based on at least one of or a combination of Cr, Fe, Cu, Ni, Al, Ca, Na, Zn, B and Ti concentrations, between the outer surface and the bulk portion of the outer surface portion. According to an embodiment, the impurity levels are based on one of or both Fe and Cr.

In this context, according to another embodiment of the second aspect of present invention, a semiconductor processing component having an outer surface portion formed by chemical vapor deposition of SiC is provided, and a target portion of the outer surface portion is removed, such that a surface impurity level of the outer surface portion is not greater than about ten times the bulk impurity level of the outer surface portion. While a maximum 10X difference in impurity levels between the bulk and the surface is generally desired, further embodiments have a surface impurity level that is not greater than about five times, such as not greater than about two times the bulk impurity level. Indeed, certain embodiments have a surface impurity level that is not greater than the bulk impurity level.

The semiconductor processing component according to embodiments herein may be chosen from one of various geometric configurations for different processing operations as already discussed above, and may be configured for receiving various sized wafers, whether 150mm, 200mm, or newer generation 300mm wafers, for example. Particular processing components include semiconductor wafer paddles, process tubes, wafer boats, liners, pedestals, long boats, cantilever rods, wafer carriers, vertical process chambers, and even dummy wafers. Of the foregoing, several of the semiconductor processing components may be those that are configured for direct contact with and for receiving semiconductor wafers such as horizontal or vertical wafer boats, long boats, and wafer susceptors. In addition, the processing component may be configured for single wafer processing and may be used for chambers, focus rings, suspension rings, susceptors, pedestals, etc.

The semiconductor processing component may be fabricated by various techniques. For example, according to one embodiment, the processing component is formed by provision of a substrate that is generally coated with a SiC layer by CVD. The CVD-SiC layer may advantageously function to attenuate auto-doping of the underlying silicon, as well as prevent migration of impurities from the bulk of the substrate to an outer surface of the component, which may lead to contamination during semiconductor wafer processing. The substrate typically functions to provide mechanical support and structural integrity, and may be formed of various materials, such as recrystallized SiC, and by various processing pathways. In one technique, the substrate, primarily composed of SiC, is formed by slip casting or by pressing. In the case of slip casting, the slip-cast body is dried and heat treated, followed optionally by impregnation to reduce porosity. Advantageously, impregnation may be carried out by infiltration with molten silicon. Other specialized fabrication techniques may also be used, such as by utilizing a conversion process in which a carbon preform is converted into a silicon carbide core, or by subtractive process in which the core is removed following infiltration, such as by chemical vapor infiltration.

Alternatively, the semiconductor processing component may be formed of stand-alone silicon carbide, formed of one of various processes such as by CVD of silicon carbide. This particular process technique enables formation of a processing component that is of relatively high purity throughout substantially the entire bulk or interior portion of the component.

Following formation of the processing component, the processing component is subjected to a treatment process. Namely, the outer portion of the component formed of CVD-SiC is manipulated to improve purity, and particularly, the impurity of the outer surface. In one embodiment, a target portion of the outer surface portion is removed, leaving behind an outer surface that has an impurity content that is not greater than ten times that of a bulk impurity content of the outer surface portion.

Removal of the target portion may be carried out by any one of several techniques. According to one technique, the outer surface portion is removed by an oxidation-stripping process, as already discussed above. However, for the sake of clarity, the oxidation-stripping process is described below as well. During oxidation, the component may be exposed to a reactant species, such as a halogen gas, to further improve purity. The reactant species generally functions to complex or react with existing impurities, and volatilize during high temperature treatment. Oxidation-stripping may also reduce particle count along the outer surface, particularly beneficial in the context of semiconductor processing operations.

In more detail, oxidation of the semiconductor processing component is generally carried out to form an oxide layer by chemical reaction to form a conversion layer, as opposed to a deposited oxide layer. According to the oxidation treatment, an oxide layer consumes a target portion of the component, namely a portion of the CVD-SiC material. The oxide layer may be formed by oxidation of the component in an oxidizing environment, such as by oxidizing the component in an oxygen containing environment at an elevated temperature, such as within a range of 950 to about 1300 degrees C, and more specifically in a range of about 1000 to about 1250 degrees C. Oxidation may be carried out in a dry or wet ambient, and is typically carried out at atmospheric pressure. A wet ambient can be generated by introducing steam, and functions to increase the rate of oxidation. The oxide layer is generally silicon oxide, typically SiO₂. The silicon oxide layer may be in direct contact with the silicon carbide of the component, as in the case of free-standing SiC or substrates coated with silicon carbide, such as by CVD.

The oxide layer may cause residual silicon carbide particulates to be converted to silicon oxide, in addition to formation of an oxide layer along the body proper. In the case of particulate conversion, oxidation may enable later stage particulate removal. In addition, formation of an oxide coating by a conversion process, rather than a deposition process, helps trap residual impurities, such as metallic impurities, within the oxide layer, for removal along with stripping of the oxide layer.

The oxide layer may be stripped by exposure of the processing component to a solution that is capable of solubilizing (dissolving) the oxide layer. In one embodiment, the solution is an acid which contains fluorine. Typically, the pH of the solution is less than about 3.5, most typically less than about 3.0, with some embodiments being even more acidic, having a pH less than about 2.5. Alternatively, the solution may be basic, and exposed to the layer in conjunction with elevated temperatures (greater than room temp, but below H2O boiling point). Alternatively, high temperature and H2 gas, such as above 1000 °C, may also be used.

During oxidation, the semiconductor processing component may be exposed to a reactive species, such as a halogen gas, that forms a reaction product with contaminants present at the outer surface of the outer surface portion. Generally, both the exposure to a reactive species and oxidizing are carried out simultaneously, although alternatively the steps may be carried out separately. In this regard, use of the term simultaneously does not require that the exposure and oxidation steps to be carried out so as to be completely coextensive, but rather, the steps may overlap each other partially.

The term "halogen gas" denotes use of any halogen group elements provided in gaseous form, typically combined with a cation. An example of a common halogen gas which may be employed according to embodiments of the present invention includes HCl. Other gasses include those that contain fluorine, for example. Typically, the elevated temperature at which the semiconductor processing component is exposed to the halogen gas is sufficient to enable a reaction between the halogen gas and impurities contained along an outer surface portion of the semiconductor processing component, including along the exposed outer surface of the semiconductor processing component. For example, the elevated temperature may be within a range of about 950° C to about 1300° C. Further, the concentration of the halogen gas may vary, and may be present in the heated environment (e.g., a furnace processing chamber) within a range of about 0.01 to about 10% of the total pressure. Typically, the lower limit of the partial pressure is somewhat higher, such as about 0.05, or about 0.10%. While the foregoing has focused on halogen gases, other reactive anion-containing reactants may be utilized, provided that the reactant is chosen so as to form a reaction product with expected metallic impurities, and that the reaction product has a higher volatility than that of the metallic impurity itself.

Typically, the impurity with which the halogen gas reacts along an outer surface portion of the semiconductor processing component is a metal impurity. Metal impurities may take on the form of elemental metal, or metal alloys, and may be aluminum-based, iron-based, or chromium-based, for example. The use of a halogen gas such as HCl causes the formation of a reaction product with such metal impurities. The reaction product typically has a higher volatilization than the impurities, such that during the exposure of the processing component to the elevated temperature, the reaction product volatilizes and is thus removed from the processing component.

While the above disclosure has focused on removal of a portion of the component by reacting, notably by oxidation-stripping, other techniques for removing the target portion may be utilized. For example, the target portion may be reacted by an etching operation, by introducing an etchant species at an elevated temperature to form an etchant product that volatilizes to wholly or partly remove the target portion. For example, the etchant species may be a chlorine-containing gas, forming SiClₓ etchant product that volatilizes. The Cl-containing gas may be HCl, Cl₂, and others. In some cases, carbon may be left behind as a by-product of the etching operation. This carbon may be removed by a high temperature burn-out treatment. It is noted that sometimes etching is referred to as graphitization, describing the carbon in the form of graphite left behind on the surface of the component. It is also generally desirable that the etchant used complexes with the impurities present along the outer surface portion, forming volatilized species such as FeCl, TiCl, etc. Further, as described above, to the extent that oxidation and oxide stripping are utilized to remove the target portion, the contaminants may be reacted to form a reaction product, such as by introducing a halogen gas as already described above in detail.

Prior to removal of the target portion by any of the techniques disclosed herein, the component may be subjected to a machining operation, to remove, for example 10 to 100 microns of outer material of the component. While the as-deposited impurity profile is generally altered by material removal from machining operations, machining tends to nevertheless leave a spike in impurities at the outer surface of the component (i.e., the as-machined surface), as similarly observed in as-deposited CVD SiC. It has been found that the surface impurity level may extend into the outer surface portion, such as on the order of 1-3 microns, before reaching the bulk impurity level. Accordingly, in embodiments that have been subjected to machining, oftentimes the target portion to be removed has a thickness at the higher end of the above noted range of up to about 20 microns, with actual thicknesses removed on the order of 3 to 5 microns. Accordingly, to the extent that the CVD-SiC surface of the component is subjected to a mechanical abrasion or machining process such as grinding, lapping or polishing, prior to removal of the target portion, further removal would generally be effected due to elevated contamination levels present in the post-machined surface. Removal of the target portion may executed with oxidation-strip cycles or etching cycles, for example, carried out enough times to effect high purity.

According to another feature, removal of the target portion is carried out prior to use of the processing component in a semiconductor fabrication environment. As such, the foregoing steps may be carried out off-site, separate from the semiconductor fabrication environment, such as by the manufacturer of the processing component rather than the end user (e.g., the semiconductor component manufacturer/wafer processor). The processing component may be fully treated, then packaged in a hermetic shipping container for direct and immediate use in a fabrication environment. While the foregoing has focused on one cycle, processing steps such as oxidation-steps (with optional halogen gas treatment) may be repeated, and is generally repeated, several times to achieve the desired level of purity through removal of the target portion.

According to a variant, additional processing steps may be incorporated prior to exposure to removal of the target portion, with an aim to further reduce impurity levels. For example, the component may be rinsed, such as with deionized (DI) water, prior to exposure to halogen gas and subsequent processing. Agitation may be carried out during rinsing, such as with an ultrasonic mixer/agitator, to further supplement contaminant removal. Further, the rinsing solution may be acidic solution to aid in stripping the contaminants.

Alternatively, or in addition to rinsing, the component may be immersed in an acidic stripping solution prior to halogen species exposure, such as an acidic solution, to further aid in impurity removal. The rinsing and/or immersion steps may be repeated any number of times prior to further processing.

Due to the observed depth profiling as described in more detail below, typically the target portion has a thickness of at least about 0.25 microns, such as 0.38 microns, 0.50 microns, and even higher. Indeed, the target portion most generally has a thickness of at least 1.0 microns, and preferably at least about 2, such as about 2-10 microns microns, but generally less than 20 microns. Typically the CVD-SiC layer has a thickness with a range of about 10 to 1000 *µ*m and certain embodiments have a thickness up to about 800 *µ*m, 600 *µ*m, 400 *µ*m, or up to about 200 *µ*m. The thickness of the target portion corresponding to the depth of removal of the outer surface portion of the component is generally chosen to ensure the desired surface impurity reduction, such as driving the impurity content down from 1,000 X of bulk to on the order of 10 X of bulk, or even lower. Indeed, the surface impurity level is generally reduced by at least one order of magnitude if not two orders of magnitude as a result of the removal of the target portion.

With respect to the particular measurement techniques for characterizing pre- and post-treated CVD-SiC films, particular use is made of Secondary Ion Mass Spectroscopy (SIMS). Other techniques include GDMS, for example. As used herein, the bulk impurity level generally corresponds to the impurity level at a depth within the outer surface portion at which the purity level is stabilized, that is, is generally constant further into the depth of the outer surface portion. It is noted that impurity detection usually entails some degree of variance, represented by swings in measured impurity levels as a function of depth. Unless otherwise noted herein, while raw data is reported, specific impurity level data points, and particularly the bulk impurity level, are based upon a trend of the impurity contents according to the data, that is, smoothed data. According to characterization studies reported herein, it was found that typically the bulk impurity level is typically reached by a depth of 3 microns. Accordingly, the bulk impurity level may be taken at a depth within a range of about 3 to 10 *µ*m, such as within a range of 3 to 5 *µ*m, for example. The particular depth value at which the bulk impurity level is reached, however, may be dependent on processing conditions of the particular CVD process utilized to form the outer surface portion, including particular tool used, gases used, temperature, pressure, and other processing parameters.

According to a particular embodiment, the bulk impurity level is not greater than about 1e17 atoms/cc iron (Fe) and not greater than 1e15 atoms/cc chromium (Cr). Of course, more demanding end use applications of processing components may call for even lower bulk impurity levels than the foregoing, such as 1e16 atms/cc iron (Fe).

The data and following discussion focus on characterization studies done on several as-deposited CVD-SiC samples as well as on post-treated CVD-SiC samples.

Si:SiC coupons of size 25 mm x 75 mm x 6 mm were prepared using standard processing. The coupons were ultrasonically cleaned in dilute acid, DI water rinsed, and dried. The cleaned coupons were loaded into the CVD reactor and a CVD film between 12-18 microns in thickness was deposited on the surface of the Si:SiC coupons. Multiple coating runs were performed using two different coating systems (Apparatus A and Apparatus B) to further understand equipment effects on coating purity.

The impurity level on the surface of the CVD coated Si:SiC coupons was analyzed by Secondary Ion Mass Spectroscopy (SIMS). The SIMS analysis was conducted with O₂⁺ plasma using a Cameca 3f instrument in a depth profile mode. The instrument was calibrated using ion implanted SiC standards for accurate impurity determination. The analysis was focused on Fe and Cr alone to enable a good detection limit, viz. 1e15 atoms/cc for Fe and 1e14 atoms/cc for Cr. Unless otherwise noted, the results described hereinafter represent as-deposited or as-removed CVD-SiC, with no intermediate machining operations.

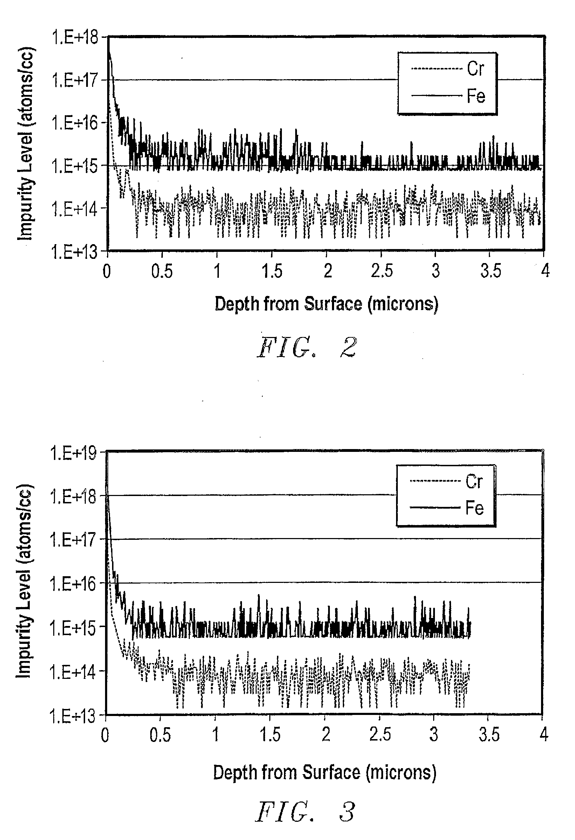

The SIMS analysis of the CVD-SiC layer of a sample processed by Apparatus A, indicates a high surface contamination of both Fe and Cr that is 500-1000 times higher than the bulk value as shown in FIG. 2. The Fe concentration in the bulk is <1e15 atoms/cc and the Cr concentration is <1e14 atoms/cc, which is typical for CVD-SiC coatings.

A similar high surface impurity concentration was also observed on the CVD-SiC layer deposited using Apparatus B, as shown in FIG. 3.

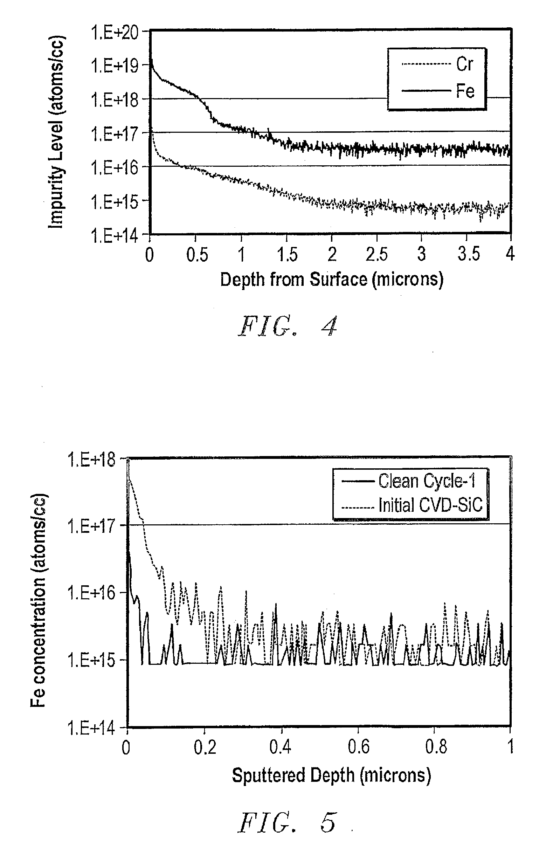

The surface Fe concentration is >1e18 atoms/cc and drops to the bulk value of <1e15 atoms/cc within 0.5 microns depth into the CVD-SiC coating for the particular samples under characterization. To verify the universality of high impurity concentration on the surface of as-deposited coatings, a third test was conducted on a CVD-SiC coating with higher impurities in the reactant gases used to form the CVD film. Impurity enrichment was also observed on coatings with higher impurity levels as shown in FIG. 4. The Fe concentration at the surface is >1e19 atoms/cc, and drops over 2-2.5 microns to the bulk Fe concentration of 5 e16 atoms/cc. The Cr at the surface is 5e17 atoms/cc, which is a factor of 550 higher than the bulk Cr concentration of 7e14 atoms/cc. The relatively gradual drop in impurity concentration from the surface to the bulk may be related to differences in surface roughness between the coatings under characterization.

Mechanisms for impurity enrichment at the surface are not well understood at the present but may relate to impurity migration from the surface of the Si:SiC substrate during the CVD-SiC deposition process or Fe segregation from the interior of the film to the surface during cooling.

Two different types of CVD-SiC coatings were produced with Apparatus A, a standard coating and a lower-purity coating, were selected for cleaning processing. The coupons were loaded onto a CVD coated cantilever paddle and placed into a diffusion furnace equipped with a SiC process tube.

The coupons were oxidized at 950-1350°C for 6-14 hours in flowing 02 with up to 10% HCl gas. The thermal treatment conditions were selected to enable the growth of a thick thermal oxide on the CVD-SiC surface through consumption of a target portion of the CVD-SiC corresponding to about 0.45-0.60, nominally 0.5 times the thickness of the oxide. The oxidation process helps to concentrate the transition metal impurities such as Fe into the oxide layer on the CVD-SiC. While the HCl gas helps to volatilize the impurities on the surface of the growing oxide, HCl treatment is not believed to significantly remove metal trapped within the growing oxide layer. The overall process consumes the contaminated target portion of the CVD-SiC layer through the reaction, SiC + 3/2 02 (g) = SiO2 + CO(g) to form SiO2.

To remove the bulk impurities within the oxide layer, the oxide layer was stripped in an acid bath using a HF-HCl mixture (1:1 acid mixture). The resulting impurity concentration at the surface is shown in FIG. 5.

SIMS analysis indicates that the surface Fe concentration decreases from >5e17 atoms/cc on the initial CVD-SiC coupon to <5e16 atoms/cc on the cleaned coupon, a 10 fold improvement due to cleaning. The bulk impurity concentration remained constant at <1e15 atoms/cc. While the cleaning cycle decreased surface impurity concentration, the surface impurity concentration was still a factor of 50 higher than the bulk. Thus, an additional cleaning cycle was conducted to further decrease the Fe concentration at the surface. The effect of the 2^{nd} cleaning cycle could not be quantified using SIMS due to detection limit issues and noise in the analysis. Accordingly the cleaning cycles were repeated using the CVD-SiC sample with higher impurities (shown in FIG. 4) to help discern minor differences between the surface and bulk impurity levels.

The lower purity CVD-SiC sample was cleaned similar to the standard CVD-SiC sample. The coupons were first oxidized at 950-1350°C for 6-14 hours in flowing 02 with up to 10% HCl gas to grow an oxide layer that was subsequently stripped by the HF-HCl solution. The cleaning cycle was repeated a second time to remove material deeper into the CVD-SiC surface and thereby remove the Fe-enriched surface layer.

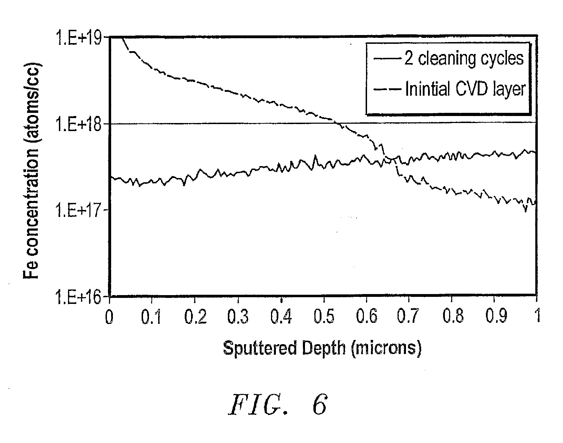

SIMS analysis of coupons after two cleaning cycles is shown in FIG. 6. The double cleaning cycle was effective to completely remove the contaminated surface layer, and the surface impurity concentration is similar to the bulk impurity concentration.

It is again noted that, while the foregoing characterization studies have taken advantage of repeated oxidation-strip cycles coupled with halogen gas treatment, other removal techniques may be employed for removal of the target portion. Further, it has been found that repeated removal steps may be carried out in order to drive the surface impurity levels to a desirable range as described above, a single cycle resulted in a surface impurity level that was dramatically improved, but still having an impurity level that was 50 X that of the bulk. Accordingly, repeated cycles are generally carried out to ensure bulk-like purity at the surface.

Still further, as demonstrated by FIG. 6, the techniques described herein may be carried out to reduce the impurity level of the surface to be not greater than the bulk impurity level, that is, about equal to or less than the bulk impurity level. Note that the data shown in FIG. 6 were taken from two different samples, and are provided for comparative purposes to show impurity trends before and after treatment.

The above-disclosed subject matter is to be construed as illustrative and not restrictive, and the appended claims are intended to cover all such modifications, enhancements, and other embodiments that fall within the scope of the present invention. Thus, to the maximum extent allowed by law, the scope of the present invention is to be determined by the broadest permissible interpretation of the following claims and their equivalents and shall not be restricted or limited by the foregoing detailed description.

Thus, the present description relates inter alia to the following aspects of the invention

The present invention is firstly (1.) concerned with a method for treating a semiconductor processing component, comprising: exposing the component to a halogen gas at an elevated temperature; oxidizing the component to form an oxide layer; and removing the oxide layer.
2. Moreover, the present invention relates to the method of 1., wherein the steps of exposing the component to halogen gas and oxidizing the component are carried out simultaneously.
3. Moreover, the present invention relates to the method of 1., wherein the halogen gas comprises a halogen from the group consisting of chlorine and fluorine.
4. Moreover, the present invention relates to the method of 3., wherein the halogen gas comprises HCl.
5. Moreover, the present invention relates to the method of 1., wherein the halogen gas is present at a partial pressure within a range of about 0.01 to about 10%.
6. Moreover, the present invention relates to the method of 1., wherein the step of oxidizing the component is carried out at a temperature within a range of about 950 to about 1300 °C.
7. Moreover, the present invention relates to the method of 1., wherein the step of oxidizing is carried out in a wet ambient atmosphere.
8. Moreover, the present invention relates to the method of 1., wherein the semiconductor processing component has a metal impurity, and the halogen gas reacts with the metal impurity to form a reaction product which volatilizes during the step of exposing.
9. Moreover, the present invention relates to the method of 1., wherein the semiconductor processing component comprises a component from the group consisting of semiconductor wafer paddles, process tubes, wafer boats, liners, pedestals, long boats, cantilever rods, wafer carriers, process chambers, dummy wafers, wafer susceptors, focus rings, suspension rings.
10. Moreover, the present invention relates to the method of 1., wherein the semiconductor processing component comprises silicon carbide.
11. Moreover, the present invention relates to the method of 10., wherein the semiconductor processing component is formed by chemical vapor deposition.
12. Moreover, the present invention relates to the method of 10., wherein the semiconductor processing component comprises a substrate and a silicon carbide coating overlying the substrate.
13. Moreover, the present invention relates to the method of 12., wherein the silicon carbide coating is deposited by chemical vapor deposition.
14. Moreover, the present invention relates to the method of 12., wherein the substrate comprises elemental silicon.
15. Moreover, the present invention relates to the method of 14., wherein the substrate comprises silicon carbide with said elemental silicon impregnated thereon.
16. Moreover, the present invention relates to the method of 1., wherein the step of removing the oxide layer is carried out by exposing the oxide layer to a solution to solubilize the oxide layer.
17. Moreover, the present invention relates to the method of 1., further comprising machining the component prior to the exposing and oxidizing steps.
18. Moreover, the present invention relates to the method of 1., wherein the oxide layer is removed prior to use in a semiconductor processing operation.
19. Moreover, the present invention relates to the method of 1., further comprising a step of exposing the component to a stripping solution prior to exposure to halogen gas.
20. Moreover, the present invention relates to the method of 19., wherein the stripping solution comprises an acidic solution.
21. Furthermore, the present invention is concerned with a method for removing a contaminant from a semiconductor processing component, comprising: reacting the contaminant at an elevated temperature to form a reaction product; oxidizing the component to form an oxide layer; and removing the oxide layer.
22. Moreover, the present invention relates to the method of 21., wherein the steps of reacting and oxidizing are carried out simultaneously.
23. Moreover, the present invention relates to the method of 21., wherein the reaction product has a higher volatility than the contaminant.
24. Moreover, the present invention relates to the method of 23., wherein the reaction product vaporizes at said elevated temperature so as to be removed from the semiconductor processing component.
25. Furthermore, the present invention is concerned with a method for a treating a semiconductor processing component, comprising: reacting a contaminant contained along a surface portion of the component, at an elevated temperature to form a reaction product, wherein the outer surface portion has a surface roughness less than about 2 microns.
26. Moreover, the present invention relates to the method of 25., wherein the component has an impurity content of less than about 1000 ppm along said outer surface portion of the component as measured by SIMS at a depth of 10 nm from the surface of the component.
27. Furthermore, the present invention is concerned with a semiconductor processing component comprising silicon carbide, the component having a surface having an Ra less than about 2 microns, and an impurity content of less than about 1000 ppm along an outer portion of the component as measured by SIMS at a depth of 10 nm from the surface of the component.
28. Moreover, the present invention relates to the method of 27., wherein the component comprises a substrate and a silicon carbide coating thereon.
29. Moreover, the present invention relates to the method of 27., wherein the component is machined to have said Rₐ less than about 2 microns.
30. Moreover, the present invention relates to the method of 27., wherein said impurity content is less than about 500 ppm.
31. Moreover, the present invention relates to the method of 27., wherein said impurity content is less than about 200 ppm.
32. Furthermore, the present invention is concerned with a semiconductor processing component for receiving a semiconductor wafer, the component having a surface having an Ra less than about 2 microns, and an impurity content of less than about 1000 ppm along an outer portion of the component, as measured by SIMS at depth of 10 nm from the surface.
33. Furthermore, the present invention is concerned with a semiconductor processing component comprising SiC, wherein an outer surface portion of the component has a surface impurity level that is not greater than 10 times a bulk impurity level.
34. Moreover, the present invention is concerned with the component of 33., wherein the bulk impurity level is measured at a depth of at least 3 µm from an outer surface of the outer surface portion.
35. The Moreover, the present invention relates to the component of 33., wherein the outer surface portion is comprised of CVD-SiC.
36. Moreover, the present invention relates to the component of 35., wherein the outer surface portion is a CVD-SiC layer deposited over a substrate.
37. Moreover, the present invention relates to the component of 36., wherein the substrate comprises SiC.
38. Moreover, the present invention relates to the component of 37., wherein the substrate comprises SiC impregnated with elemental silicon.
39. Moreover, the present invention relates to the component of 38., wherein the substrate comprises recrystallized SiC impregnated with elemental silicon.
40. Moreover, the present invention relates to the component of 36., wherein the CVD-SiC layer has a thickness within a range of about 10 to about 1000 µm.
41. Moreover, the present invention relates to the component of 35., wherein the component is a free-standing CVD-SiC component.
42. Moreover, the present invention relates to the component of 41., wherein the component consists essentially of CVD-SiC.
43. Moreover, the present invention relates to the component of 33., wherein the surface impurity level is not greater than 5 times the bulk impurity level.
44. Moreover, the present invention relates to the component of 33., wherein the surface impurity level is not greater than 2 times the bulk impurity level.
45. Moreover, the present invention relates to the component of 33., wherein the surface impurity level is not greater than the bulk impurity level.
46. Moreover, the present invention relates to the component of 33., wherein the surface impurity and bulk impurity levels are based on at least one of Cr, Fe, Cu, Ni, Al, Ca, Na, Zn, V, B, and Ti concentrations
47. Moreover, the present invention relates to the component of 46., wherein the surface impurity and bulk impurity levels are based on at least one of Cr and Fe concentrations.
48. Moreover, the present invention relates to the component of 47., wherein the surface impurity and bulk impurity levels are based on Fe concentration.
49. Moreover, the present invention relates to the component of 47., wherein the bulk impurity level is not greater than 1 E17 atoms/cc Fe and not greater than IE15 atoms/cc Cr.
50 Moreover, the present invention relates to the component of 33., wherein the semiconductor processing component comprises a component from the group consisting of semiconductor wafer paddles, process tubes, wafer boats, liners, pedestals, long boats, cantilever rods, wafer carriers, process chambers, dummy wafers, wafer susceptors, focus rings, suspension rings.
51. Moreover, the present invention relates to the component of 50., wherein the component is a wafer boat.
52. Moreover, the present invention relates to the component of 33., wherein the component is machined prior to treatment to provide said surface impurity level.
53. Furthermore, the present invention is concerned with a method for treating a semiconductor processing component, comprising:
   providing a semiconductor processing component having an outer surface portion formed by chemical vapor deposition of SiC, the outer surface portion having a bulk impurity level and a surface impurity level ; and removing a target portion of the outer surface portion, such that the surface impurity level is not greater than 10 times the bulk impurity level.
54. Moreover, the present invention relates to the method of 1., wherein the surface impurity level is not greater than 5 times the bulk impurity level.
55. Moreover, the present invention relates to the method of 1., wherein the surface impurity level is not greater than 2 times the bulk impurity level.
56. Moreover, the present invention relates to the method of 1., wherein the surface impurity level is not greater than the bulk impurity level.
57. Moreover, the present invention relates to the method of 1., wherein the target portion is removed by reacting the target portion.
58. Moreover, the present invention relates to the method of 57., wherein reacting is oxidizing such that the outer surface portion forms an oxide, and the step of removing the target portion further includes removal of the oxide.
59. Moreover, the present invention relates to the method of 58., wherein oxidizing and removal of the oxide are repeated to remove said target portion.
60. Moreover, the present invention relates to the method of 57., wherein the target portion is removed by etching.
61. Moreover, the present invention relates to the method of 60., wherein etching includes reacting the target portion with an etchant species to form an etchant product, the etchant product volatilizing to remove the target portion.
62. Moreover, the present invention relates to the method of 61., wherein the etchant species is a Cl-containing gas, forming a SiClx etchant product.
63. Moreover, the present invention relates to the method of 1., further comprising reacting contaminants present at an outer surface of the outer surface portion to form a reaction product.
64. Moreover, the present invention relates to the method of 63., wherein the target portion is removed by oxidizing the outer surface portion to form an oxide followed by removal of the oxide, and the steps of reacting and oxidizing are carried out simultaneously.
65. Moreover, the present invention relates to the method of 63., wherein the contaminants are reacted with a halogen gas.
66. Moreover, the present invention relates to the method of 1., wherein the semiconductor processing component comprises a component from the group consisting of semiconductor wafer paddles, process tubes, wafer boats, liners, pedestals, long boats, cantilever rods, wafer carriers, process chambers, dummy wafers, wafer susceptors, focus rings, suspension rings.
67. Moreover, the present invention relates to the method of 1., wherein the semiconductor processing component comprises a substrate, the outer surface portion being a coating overlying the substrate.
68. Moreover, the present invention relates to the method of 12., wherein the substrate comprises elemental silicon.
69. Moreover, the present invention relates to the method of 14., wherein the substrate comprises silicon carbide with said elemental silicon impregnated thereon.
70. Moreover, the present invention relates to the method of 1., wherein the target portion is removed prior to use in a semiconductor processing operation.
71. Moreover, the present invention relates to the method of 1., wherein target portion is removed by repeating removal steps.
72. Moreover, the present invention relates to the method of 1., wherein the target portion has a thickness of at least 0.25 µm.
73. Moreover, the present invention relates to the method of 1., wherein the target portion has a thickness of at least 0.38 µm.
74. Moreover, the present invention relates to the method of 1., wherein the target portion has a thickness of at least 0.50 µm.
75. Moreover, the present invention relates to the method of 1., further comprising machining the component prior to removing of the target portion.
76. Furthermore, the present invention is concerned with a method for treating a semiconductor processing component, comprising: providing a semiconductor processing component having an outer surface portion formed by chemical vapor deposition of SiC, the outer surface portion having a bulk impurity level and a surface impurity level; and removing a target portion of the outer surface portion, such that the surface impurity level is reduced at least 10x.
77. Moreover, the present invention relates to the method of 76., wherein the surface impurity level is reduced at least 100x.

## Claims

1. A semiconductor processing component comprising SiC, wherein an outer surface portion of the component has a surface impurity level that is not greater than 10 times a bulk impurity level.

2. The component of claim 1, wherein the bulk impurity level is measured at a depth of at least 3 µm from an outer surface of the outer surface portion.

3. The component of claim 1, wherein the outer surface portion is comprised of CVD-SiC.

4. The component of claim 3, wherein the outer surface portion is a CVD-SiC layer deposited over a substrate.

5. The component of claim 4, wherein the substrate comprises SiC.

6. The component of claim 5, wherein the substrate comprises SiC impregnated with elemental silicon.

7. The component of claim 6, wherein the substrate comprises recrystallized SiC impregnated with elemental silicon.

8. The component of claim 4, wherein the CVD-SiC layer has a thickness within a range of about 10 to about 1000 µm.

9. The component of claim 3, wherein the component is a free-standing CVD-SiC component.

10. The component of claim 9, wherein the component consists essentially of CVD-SiC.

11. The component of claim 1, wherein the surface impurity level is not greater than 5 times the bulk impurity level.

12. The component of claim 1, wherein the surface impurity level is not greater than 2 times the bulk impurity level.

13. The component of claim 1, wherein the surface impurity level is not greater than the bulk impurity level.

14. The component of claim 1, wherein the surface impurity and bulk impurity levels are based on at least one of Cr, Fe, Cu, Ni, Al, Ca, Na, Zn, V, B, and Ti concentrations.

15. The component of claim 14, wherein the surface impurity and bulk impurity levels are based on at least one of Cr and Fe concentrations.

16. The component of claim 15, wherein the surface impurity and bulk impurity levels are based on Fe concentration.

17. The component of claim 15, wherein the bulk impurity level is not greater than 1E17 atoms/cc Fe and not greater than 1E15 atoms/cc Cr.

18. The component of claim 1, wherein the semiconductor processing component comprises a component from the group consisting of semiconductor wafer paddles, process tubes, wafer boats, liners, pedestals, long boats, cantilever rods, wafer carriers, process chambers, dummy wafers, wafer susceptors, focus rings, suspension rings.

19. The component of claim 18, wherein the component is a wafer boat.

20. The component of claim 1, wherein the component is machined prior to treatment to provide said surface impurity level.
